# EUROPÄISCHE PATENTSCHRIFT

(11) **EP 2 545 387 B1**
(45) Veröffentlichungstag und Bekanntmachung des Hinweises auf die Patenterteilung: **27.05.2020**
(21) Anmeldenummer: 11707996.2
(22) Anmeldetag: 20.01.2011
(51) Int. Cl.: G01R 21/04, G01R 1/067

(54) **MESSSPITZE MIT INTEGRIERTEM MESSWANDLER**
MEASURING TIP COMPRISING AN INTEGRATED MEASURING TRANSDUCER
POINTE DE MESURE À TRANSDUCTEUR INTÉGRÉ

(30) Priorität: 11.08.2010 DE 102010033991; 12.05.2010 DE 102010020296; 11.03.2010 DE 102010011009
(43) Veröffentlichungstag der Anmeldung: 16.01.2013
(73) Patentinhaber: Rohde & Schwarz GmbH & Co. KG, 81671 München (DE)
(72) Erfinder: DEUTINGER, Andrea, 85669 Pastetten (DE); HECHTFISCHER, Gerd, 85591 Vaterstetten (DE); EVERS, Christian, 85551 Kirchheim (DE)
(74) Vertreter: Körfer, Thomas
(86) Internationale Anmeldenummer: PCT/EP2011/000219
(87) Internationale Veröffentlichungsnummer: WO 2011/110255

(56) Entgegenhaltungen:
- EP-A1- 0 624 801
- EP-A1- 1 004 883
- EP-A2- 0 257 833
- EP-A2- 0 559 274
- WO-A1-2006/066676
- GB-A- 2 298 518
- US-A- 5 495 173
- US-A1- 2004 057 495
- US-A1- 2007 285 085
- US-A1- 2008 252 298
- US-A1- 2009 189 621
- SHAKOURI M S: "500 GHZ GAAS MMIC SAMPLING WAFER PROBE", ELECTRONICS LETTERS, IEE STEVENAGE, GB, Bd. 29, Nr. 6, 18. März 1993 (1993-03-18), Seiten 557-558, XP000364085, ISSN: 0013-5194
- RUAI Y YU ET AL: "MILLIMETER-WAVE ON-WAFER WAVEFORM AND NETWORK MEASUREMENTS USING ACTIVE PROBES", IEEE TRANSACTIONS ON MICROWAVE THEORY AND TECHNIQUES, IEEE SERVICE CENTER, PISCATAWAY, NJ, US, Bd. 43, Nr. 4, PART 01, 1. April 1995 (1995-04-01), Seiten 721-729, XP000496276, ISSN: 0018-9480, DOI: DOI:10.1109/22.375217
- YU R ET AL: "Full two-port on-wafer vector network analysis to 120 GHz using active probes", 14. Juni 1993 (1993-06-14), MICROWAVE SYMPOSIUM DIGEST, 1993., IEEE MTT-S INTERNATIONAL ATLANTA, GA, USA 14-18 JUNE 1993, NEW YORK, NY, USA,IEEE, US, PAGE(S) 1339 - 1342, XP010068444, ISBN: 978-0-7803-1209-8 Seite 1339 - Seite 1340; Abbildung 1
- DROUIN S ET AL: "An MHMIC K-Band Direct Conversion Demodulator in CPW", EUROPEAN MICROWAVE CONFERENCE, 2003. 33RD, IEEE, PISCATAWAY, NJ, USA, 1. Oktober 2003 (2003-10-01), Seiten 139-142, XP031069675,
- DANIEL E S ET AL: "A 20 GS/s 5-Bit SiGe BiCMOS Dual-Nyquist Flash ADC With Sampling Capability up to 35 GS/s Featuring Offset Corrected Exclusive-Or Comparators", IEEE JOURNAL OF SOLID-STATE CIRCUITS, IEEE SERVICE CENTER, PISCATAWAY, NJ, USA, Bd. 44, Nr. 9, 1. September 2009 (2009-09-01), Seiten 2295-2311, XP011275832, ISSN: 0018-9200, DOI: 10.1109/JSSC.2009.2022672

## Beschreibung

Die vorliegende Erfindung bezieht sich auf eine Messvorrichtung zur Erfassung eines Messsignals von einer auf einem Wafer (Schaltungsträger z.B. aus einem Halbleitermaterial) aufgebrachten Schaltungsstruktur.

Im Zuge der Herstellung von integrierten Schaltungen, wie z.B. von Verstärkerschaltungen, von denen eine Vielzahl auf einem Wafer angeordnet sind, ist es wichtig, möglichst früh festzustellen zu können, welche dieser integrierten Schaltungen funktionsfähig sind. Immer kleiner werdende Schaltungsstrukturen führen zu einer gesteigerten Ausfallrate während des Produktionsprozesses. Würde man die integrierten Schaltungen erst dann auf ihre Funktionsfähigkeit überprüfen, nachdem sie in ihr Gehäuse integriert sind, so würden unnötige Kosten für die hierfür anfallenden Produktionsschritte entstehen. Um Produktionskosten einzusparen, werden die integrierten Schaltungen schon auf ihre Funktionsfähigkeit überprüft, noch bevor sie aus dem Wafer vereinzelt werden. Hierzu beinhaltet jede integrierte Schaltung kleine Testanschlüsse, sog. Pads, an denen Messsignale angelegt und gemessen werden können. Später dienen diese Testanschlüsse der Aufnahme der Bonddrähte. Für die Messungen sind spezielle Wafer-Messvorrichtungen (engl. Wafer-Prober) erforderlich, die sehr kleine Messspitzen aufweisen und in ihrer räumlichen Position sehr genau justierbar sind.

Aus der WO 00/79293 A1 ist eine Vorrichtung zum Überprüfen der Funktionsfähigkeit von einzelnen auf einen Wafer aufgebrachten Schaltungsstrukturen bekannt. Dabei wird der zu überprüfende Wafer auf eine höhenverstellbare Unterlage aufgespannt und gegen elastisch angeordnete Nadeln gedrückt. Die Nadeln selbst sind mit einer Prüfplatine verbunden. Die Prüfplatine ist dabei über eine federnde Verbindung mit dem Prüfkopf verbunden. Die Prüfplatine wird über den Prüfkopf mit Strom und Prüfsignalen versorgt und leitet an diesen die empfangenen Messsignale weiter.

Nachteilig an der WO 00/79293 A1 ist, dass sich die Vorrichtung nur zum Messen von Signalen mit niedrigen Frequenzen eignet. Soll allerdings die Signalleistung von integrierten Hochfrequenz-Verstärkerschaltungen gemessen werden, so bringt die beschriebene Vorrichtung verschiedene Nachteile mit sich. Weil das hochfrequente Messsignal erst innerhalb des Prüfkopfs ausgewertet wird, treten bis dorthin an verschiedenen Stellen Reflexionen auf, die das Messsignal verfälschen. Dies ist auf den langen Leitungsweg zurückzuführen, der bei einem Hochfrequenzmesssignal unter Umständen mehrere Wellenlängen lang ist. Solche Stellen sind beispielsweise der Übergang von der Nadel zu der Prüfplatine oder von der Prüfplatine über die federnd gelagerte Verbindung zu dem Prüfkopf, in welchem sich die Signalauswertung befindet, so dass mit dieser Vorrichtung keine hochfrequentes Messsignal sicher erfasst werden kann.

Das Dokument Shakouri M. S. "500 GHZ GAAS MMIC SAMPLING WAFER PROBE" ELECTRONICS LETTERS, IEE STEVENAGE, GB,Bd. 29, Nr. 6, 18.März 1993 Seiten 557-558, XP000364085; ISSN: 0013-5194 offenbart einen anderen Messwandler, wobei sich bei dem Messwandler um einen thermischen Leistungssensor handelt. Folglich zeigt das Dokument auch nicht, dass die Messvorrichtung eine Wärmesenke aufweist. Das Dokument zeigt ebenfalls nicht, dass die Messspitze und der Messwandler gemeinsam durch Abziehen von der Messvorrichtung tauschbar sind.

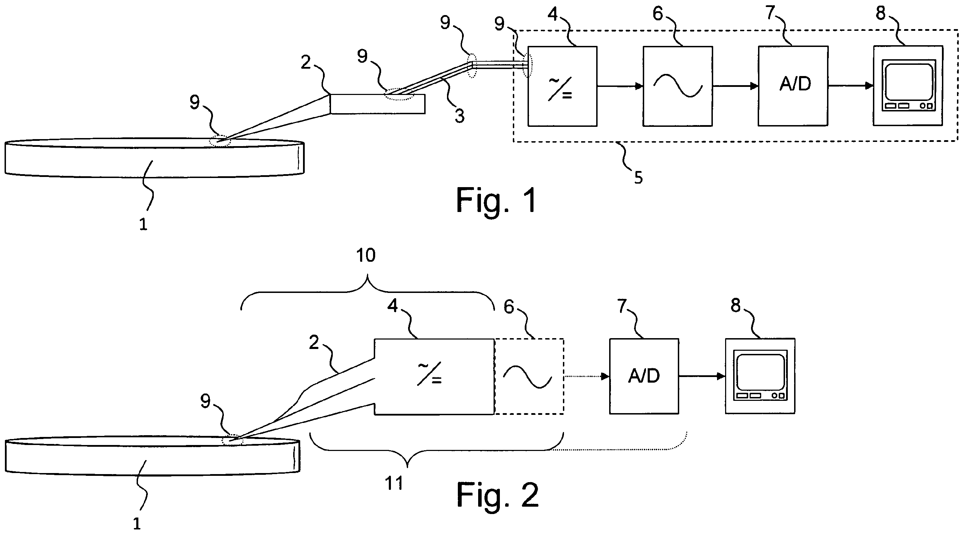

Das Dokument Ruai Y. Yu et al.: "MILLIMETER-WAVE ON-WAFER WAVEFORM AND NETWORK MEASUREMENTS USING ACTIVE PROBES" IEEE TRANSACTIONS ON MICROWAVE THEORY AND TECHNIQUES, IEEE SERVICE CENTER, PISCATAWAY, NJ, US Bd. 43, Nr. 4, Part 01, 1. April 1995 Seiten 721-729, XP000496276; ISSN: 0018-9480, DOI: 10.1109/22.375217 Seite 722 - Seite 724; offenbart in Abbildung 2 einen weiteren Messwandler, bei dem es sich nicht um einen thermischen Leistungssensor handelt. Dieses Dokument zeigt ebenfalls nicht, dass die Messvorrichtung eine Wärmesenke in Form einer Ausgleichsvorrichtung ausweist. Das Dokument zeigt weiterhin nicht, dass die Messspitze und der Messwandler gemeinsam durch Abziehen von der Messvorrichtung tauschbar sind.

Die EP 0 559 274 A2 zeigt ebenfalls nicht, dass der Messwandler an der Messspitze angeordnet ist. Dieses Dokument zeigt ebenfalls nicht, dass es sich bei dem Messwandler um einen thermischen Leistungssensor handelt und dass die Messvorrichtung eine Wärmesenke in Form einer Ausgleichsvorrichtung aufweist, und auch nicht, dass die Messspitze und der Messwandler gemeinsam durch Abziehen von der Messvorrichtung tauschbar sind.

Die WO 2006/066676 A1 zeigt ebenfalls keinen Messwandler, der an einer Messspitze angeordnet ist. Folglich sind auch die anderen Merkmale des kennzeichnenden Teils, die einen Messwandler aufweisen nicht gezeigt. Eine Wärmesenke wird deshalb auch nicht benötigt.

Auch die US 2004/057498 A1 zeigt nicht, dass der Messwandler an der Messspitze angeordnet ist und mit dieser eine untrennbare Messeinheit bildet. Eine Messspitze zum Messen einer auf einem Wafer aufgebrachten Schaltungsstruktur ist hier überhaupt nicht zu erkennen. Dieses Dokument zeigt ebenfalls nicht, dass die Messvorrichtung eine Wärmesenke in Form einer Ausgleichsvorrichtung aufweist und auch nicht, dass die Messspitze und der Messwandler gemeinsam durch Abziehen von der Messvorrichtung tauschbar sind.

Die US 2008/252298 A1 zeigt ebenfalls keinen Messwandler, der an der Messspitze angeordnet ist, und der mit dieser zusammen eine untrennbare Messeinheit bildet. Dieses Dokument zeigt ebenfalls nicht, dass die Messvorrichtung eine Wärmsenke in Form einer Ausgleichsvorrichtung aufweist und dass die Messspitze und der Messwandler gemeinsam durch Abziehen von der Messvorrichtung tauschbar sind.

Auch die EP 1 004 883 A1 zeigt keinen Messwandler der an einer Messspitze angeordnet ist und mit dieser beide gemeinsam eine untrennbare Messeinheit bildet. Dieses Dokument zeigt ebenfalls keine Messvorrichtung, die weiterhin eine Wärmesenke in Form einer Ausgleichsvorrichtung aufweist und außerdem keine Messspitze und keinen Messwandler, die gemeinsam durch Abziehen von der Messvorrichtung tauschbar sind.

Es ist daher die Aufgabe der Erfindung eine Messvorrichtung zu schaffen, mit der die Erfassung der Leistung oder des Signalverlaufs eines breitbandigen Hochfrequenz-Messsignals möglich ist.

Die Aufgabe wird bezüglich der Messvorrichtung durch die Merkmale des Anspruch 1 gelöst. In den Unteransprüchen sind vorteilhafte Weiterbildungen der erfindungsgemäßen Messvorrichtung angegeben.

Die erfindungsgemäße Messvorrichtung dient zur Erfassung eines Messsignals von einer auf einem Wafer aufgebrachten Schaltungsstruktur. Dabei weist die erfindungsgemäße Messvorrichtung zumindest eine Messspitze und zumindest einen Messwandler auf. Der zumindest eine Messwandler ist dabei elektrisch leitend mit der zumindest einen Messspitze verbunden. Der Messwandler ist dabei erfindungsgemäß an der Messspitze angeordnet.

Besonders vorteilhaft ist es, wenn der Messwandler an der Messspitze angeordnet ist. Dadurch finden keine Reflexionen zwischen der Messspitze und dem Messwandler mehr statt, wie sie z.B. durch Kabelübergänge hervorgerufen werden würden. Die Messung wird erheblich genauer und eignet sich auch für hohe Frequenzen.

Besonders von Vorteil ist es, wenn die Messspitze und der Messwandler gemeinsam von der Messvorrichtung abgezogen werden können. Die Messspitze kann dann einerseits schnell getauscht werden und andererseits muss keine erneute Kalibration erfolgen, weil der Messwandler ebenfalls getauscht wird. Die neue Messspitze und der neue Messwandler sind bereits im Herstellungsprozess kalibriert worden, so dass nach dem Austausch der Messspitze direkt mit weiteren Messungen fortgefahren werden kann.

Ein weiterer Vorteil ist es, wenn der Messwandler unmittelbar neben der Messspitze angeordnet ist und/oder dass der Messwandler direkt mit der Messspitze verbunden ist und der Messwandler und/oder die Messspitze eine Messeinheit bilden. Weil sowohl der Messwandler, als auch die Messspitze untrennbar miteinander verbunden sind, können keine weiteren Reflexionsstellen z.B. durch den Austausch einer Verbindung zwischen Messspitze und Messwandler auftreten. Dies ermöglicht es, dass die gesamte Messeinheit bereits im Produktionsprozess kalibriert werden kann. Eine weitere Kalibration ist im Betriebsablauf nicht mehr notwendig, wodurch unnötige Mehrausgaben vermieden werden und gleichzeitig die Messgenauigkeit dauerhaft erhöht wird.

Außerdem ist es von Vorteil, wenn es sich bei dem Messwandler um einen thermischen Leistungssensor handelt. Durch den Einsatz eines thermischen Leistungssensors ist es im Gegensatz zu einem Leistungssensor, welcher aus Dioden aufgebaut ist, möglich, dass die Leistung eines Messsignals im zeitlichen Mittel mit jedweder Art von Modulation genau erfasst werden kann. Thermische Leistungssensoren reagieren überdies deutlich besser auf Harmonische des Messsignals.

Schlussendlich ist es von Vorteil, wenn die erfindungsgemäße Messvorrichtung eine Ausgleichsvorrichtung aufweist und dass die Ausgleichsvorrichtung eine Signalaufbereitung und/oder einen Analog/Digital (A/D)-Wandler aufweist. Dies ermöglicht kurze Signalpfade für das analoge Messsignal und letztendlich eine kompakte Anordnung der gesamten Messvorrichtung.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: eine Übersicht über ein Blockschaltbild einer bislang üblichen Wafer-Messvorrichtung;
- Fig. 2: eine Übersicht über ein Blockschaltbild eines Ausführungsbeispiels der erfindungsgemäßen Messvorrichtung;
- Fig. 3A: eine räumliche Darstellung eines Ausführungsbeispiels der erfindungsgemäßen Messvorrichtung;
- Fig. 3B: eine räumliche Darstellung eines weiteren Ausführungsbeispiels der erfindungsgemäßen Messvorrichtung;
- Fig. 3C: eine räumliche Darstellung eines weiteren Ausführungsbeispiels der erfindungsgemäßen Messvorrichtung;
- Fig. 3D: eine räumliche Darstellung eines weiteren Ausführungsbeispiels der erfindungsgemäßen Messvorrichtung;
- Fig. 4: eine räumliche Darstellung eines Ausführungsbeispiels eines Teils der erfindungsgemäßen Messvorrichtung, die eine Steckverbindung beinhaltet;
- Fig. 5: ein Ausführungsbeispiel zur Herstellung der erfindungsgemäßen Messspitze;
- Fig. 6: eine vereinfachte Schnittzeichnung eines Ausführungsbeispiels der erfindungsgemäßen Messvorrichtung entlang der der Achse I in Fig. 1;
- Fig. 7: eine weitere vereinfachte Schnittzeichnung eines Ausführungsbeispiels der erfindungsgemäßen Messvorrichtung entlang der Achse I mit einer federnd ausgebildeten Messeinheit; und
- Fig. 8: eine mögliche Anordnung der Thermoelemente in dem Messwandler.

Fig. 1 zeigt eine bislang übliche Wafer-Messvorrichtung (engl. Wafer-proper). Auf einem Wafer (Schaltungsträger) 1 sind Schaltungsstrukturen von integrierten Schaltungen, wie z.B. Verstärkerschaltungen, aufgebracht. Ein Ende der Messspitze 2 ist leitend mit den Schaltungsstrukturen auf dem Wafer 1 verbunden. Dabei kontaktiert das eine Ende die Anschlussbereiche der einzelnen Schaltungsstrukturen auf dem Wafers 2, die später mit den Bonddrähten verbunden werden. Die Messspitze 2 ist über die Kabelverbindung 3 mit dem Messwandler 4 des Messkopfs 5 verbunden. Bei der Kabelverbindung 3 kann es sich um eine koaxiale Kabelverbindung 3 oder um eine Hohlleiter-Verbindung 3 handeln. Der Messwandler 4 ist mit einer analogen Signalverarbeitungseinheit 6 verbunden, die das analoge Messsignal für die digitale Signalverarbeitung in der digitalen Signalverarbeitungseinheit 7 aufbereitet. Die digitale Signalverarbeitungseinheit 7 weist neben einem A/D-Wandler noch einen digitalen Signalprozessor auf, der die Messdaten auswertet und an eine Ausgabeschnittstelle 8 überträgt. Bei dieser Ausgabeschnittstelle 8 kann es sich z.B. um eine USB-Schnittstelle handeln (dt. universeller serieller Bus; engl. universal serial bus).

Dadurch, dass die gesamte Messelektronik in dem Messkopf 5 integriert ist und damit von der Messspitze 2 beabstandet ist, beträgt die Länge der Leitungen von der Oberfläche des Wafers 1 bis zum Eingang des Messwandlers 4 je nach Frequenz des hochfrequenten Messsignals unter Umständen mehrere Wellenlängen. Dies führt zu unerwünschten Reflexionen 9 und Abschwächungen bei der Messsignalerfassung. Reflexionen 9 treten z.B. an den Stellen auf, an denen sich z.B. die Impedanz der Leitung ändert. Dies kann am Übergang zwischen dem Wafer 1 und der Messspitze 2 sein, oder am Übergang zwischen der Messspitze 2 und der Kabelverbindung 3, bzw. innerhalb der Kabelverbindung 3 oder am Übergang zwischen der Kabelverbindung 3 und dem Messwandler 4. Die Reflexionen 9 und die Abschwächungen sind dabei abhängig von der Frequenz des Messsignals.

Die Reflexionen 9 und Abschwächungen können zwar in den gewonnen Messdaten berücksichtigt werden, allerdings setzt dies eine genaue Charakterisierung der Übertragungsparameter der Messspitze 2 bis hin zum Messwandler 4 voraus. Im Hinblick darauf, dass die Messspitze 2 einem erhöhten Verschleiß ausgesetzt ist, muss bei jedem Tausch der Messspitze 2 die gesamte Wafer-Messvorrichtung erneut kalibriert werden. Dies ist einerseits zeitaufwendig und andererseits wird das Vorhandensein weiterer Messgeräte zwingend vorausgesetzt.

Die beschriebenen Nachteile können vermieden werden, wenn die Messspitze 2 und der Messwandler 4 gemeinsam in einer Messeinheit 10 integriert sind. Fig. 2 zeigt diesbezüglich eine Übersicht über ein Ausführungsbeispiel der erfindungsgemäßen Messvorrichtung. Der Wafer 1 ist leitend mit der Messspitze 2 verbunden. Der Messwandler 4 ist unmittelbar neben der Messspitze 2 angeordnet, so dass keine Reflexionen 9 und Abschwächungen zwischen der Messspitze 9 und dem Messwandler 4 entstehen. Ebenfalls kann die analoge Signalverarbeitungseinheit 6 und optional ein Teil der digitalen Signalverarbeitungseinheit 7 in der Nähe der Messeinheit 10 angeordnet sein. Mögliche Ausführungsformen werden in den nachfolgenden Zeichnungsfiguren ausführlich beschrieben.

Reflexionen 9 treten wenn überhaupt nur noch an dem Übergang zwischen der Oberfläche des Wafers 1 und der Messspitze 2 auf. Weitere Reflexionsstellen sind verschwunden oder bereits berücksichtigt. Gerade die einteilige, untrennbare Ausbildung zwischen der Messspitze 2 und dem Messwandler 4 erlaubt es, dass die Messeinheit 10 bereits im Herstellungsprozess vollumfänglich bzgl. ihrer Übertragungsparameter charakterisiert werden kann. Bei einem Verschleiß der Messspitze 2 wird die gesamte Messeinheit 10 getauscht und durch eine neue Messeinheit 10 ersetzt. Die notwendigen Kalibrationsdaten für die neue Messeinheit 10 liegen dieser auf einem Datenträger bei und können in die digitale Signalverarbeitungseinheit 7 geladen werden. Schlussendlich besteht kein weiteres Bedürfnis bei einem Wechsel der Messspitze 2 erneut die gesamte Messvorrichtung 11 zu kalibrieren und dafür die notwendigen Messgeräte vorzuhalten.

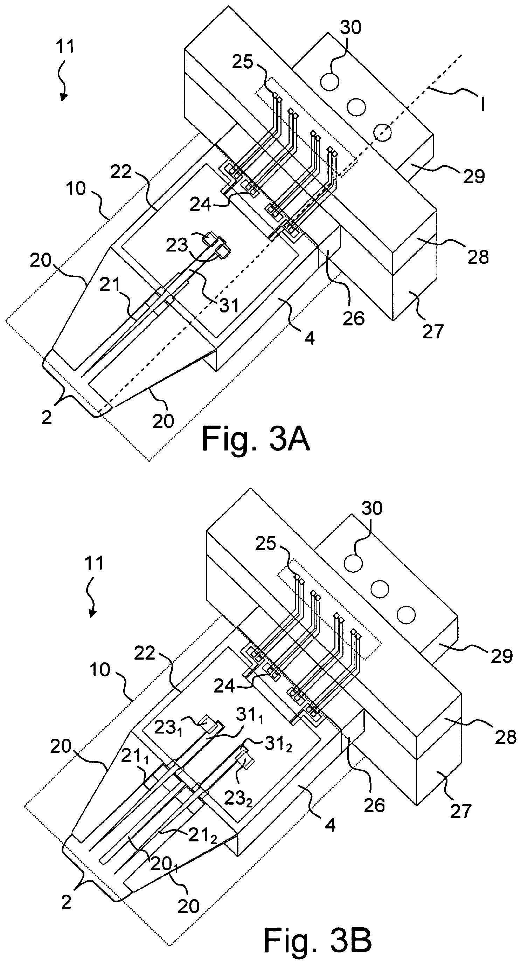

Fig. 3A zeigt eine räumliche Darstellung eines möglichen Ausführungsbeispiels der erfindungsgemäßen Messvorrichtung 11. Die erfindungsgemäße Messvorrichtung 11 weist zumindest eine Messspitze 2 und zumindest einen Messwandler 4 auf, wobei der zumindest eine Messwandler 4 elektrisch leitend mit der zumindest einen Messspitze 2 verbunden ist. Wie aus Fig. 3A ersichtlich, ist der Messwandler 4 unmittelbar und/oder direkt mit der Messspitze 2 untrennbar verbunden. Messspitze 2 und Messwandler 4 bilden eine Messeinheit 10, bzw. sie sind in einer Messeinheit 10 integriert.

Die Messspitze 2 weist zumindest eine Messsignalkontaktierung 21 und zumindest eine Massekontaktierung 20 auf, die als eigenständige Spitzen 20,21 ausgebildet sind. Über die Messsignalkontaktierung 21 ist der Messspitze 2 und damit der Messeinheit 10 ein Messsignal zugeführt. Bei diesem Messsignal handelt es sich insbesondere um ein Hochfrequenz-Messsignal. Die Spitzen 20 für die Massekontaktierung 20 sind dabei deutlich breiter als die Spitze 21 für die Messsignalkontaktierung. Die Breite der Spitze 21 für die Messsignalkontaktierung 21 beträgt z.B. ca. 20 µm. Die einzelnen Spitzen 20, 21 der Messspitze 2 sind derart dünn ausgestaltet, dass diese beim Anpressen auf einen Anschlussbereich des Wafers 1 leicht durchgebogen werden, wodurch sich eine leicht federnde Verbindung zwischen dem Wafer 1 und dem Messwandler 4 einstellt.

Bei dem Messwandler 4 handelt es sich bevorzugt um einen thermischen Leistungssensor. Dieser erzeugt in Abhängigkeit der Leistung des Messsignals, welches diesem über die Messspitze 2 zugeführt wird, ein analoges Gleichspannungsausgangssignal, welches proportional zur Leistung des Messsignals ist. Ein thermischer Leistungssensor ist genauer als eine Leistungsmessung mit Dioden und mittelt dabei jede Art von Modulation und ist unempfindlich gegenüber Harmonischen des Messsignals. Das Messsignal wird von der Messspitze 2 über eine Streifenleitung 31 oder Koplanarleitung 31 zwei Heizwiderständen 23 zugeführt und über diese gegen die Bezugsmasse abgeleitet.

Die Heizwiderstände 23 erwärmen sich dabei, wobei die abgestrahlte Wärmeenergie dafür sorgt, dass in den in unmittelbarer Umgebung angebrachten Thermoelementen 80 eine Thermospannung entsteht. Die Thermoelemente 80 sind z.B. in einer Schicht oberhalb der Heizwiderstände 23 in dem Bereich 22 angeordnet. Der Messwandler 4 weist ferner noch Verbindungsanschlüsse 24 auf, an denen ein zur Leistung des Messsignals proportionales Gleichspannungssignal abgegriffen werden kann. Weiterhin kann über diese Verbindungsanschlüsse 24 auch ein Signal eingespeist werden, welches über einen dritten nicht dargestellten Heizwiderstand gegen die Bezugsmasse abgeleitet wird. Sämtliche Heizwiderstände 23 sind thermisch unmittelbar miteinander verbunden. Wird über den dritten Heizwiderstand ein bekanntes Signal eingespeist, so kann die Genauigkeit erhöht werden.

Die Messvorrichtung 11 weist außerdem ein Verbindungselement 26 auf, welches direkt oder indirekt mit dem Messwandler 4 verbunden ist. Bei der Verbindung kann es sich z.B. um eine Klebeverbindung und/oder Klemmverbindung handeln. Das Verbindungselement 26 besteht bevorzugt aus Gold oder Messing oder einem anderen gut wärmeleitfähigen Material.

Die Messvorrichtung 11 weist weiterhin eine Ausgleichsvorrichtung 27 auf, die mit dem Verbindungselement 26 verbunden ist. Die Ausgleichsvorrichtung 27 weist einen Anschlussstecker 28 auf, wobei der Anschlussstecker 28 zusätzliche Anschlussbuchsen 25 aufweist. Über die Anschlussbuchsen 25 kann die Ausgleichsvorrichtung 27 mit einer nicht dargestellten Haltevorrichtung verbunden werden. Die Haltevorrichtung weist dabei einen Stecker auf, der in die Anschlussbuchsen 25 greift und die Datenübertragung und Energieversorgung der Messvorrichtung 11 sicherstellt.

In der Ausgleichsvorrichtung 27 ist zudem ausreichend Platz vorhanden, so dass die analoge Signalverarbeitungseinheit 6 und/oder ein Analog/Digital (A/D)-Wandler in dieser integriert sein können. Ein digitaler Signalprozessor ist in der nicht dargestellten Haltevorrichtung integriert und kommuniziert mit dem A/D-Wandler.

Die Ausgleichsvorrichtung 27 ist aus einem thermisch gut leitfähigen Material, z.B. aus Gold oder Messing, gebildet. Über das thermisch ebenfalls sehr gut leitende Verbindungselement 26 ist der Messwandler 4 über einen fest definierten Wärmewiderstand an eine Wärmesenke, z.B. in Form des Ausgleichselements 27, thermisch leitend angebunden. Erst dadurch ist die Funktionalität des Messwandlers 4 gewährleistet.

Die Messvorrichtung 11 weist außerdem ein Aufnahmeelement 29 auf, das mechanisch fest mit dem Ausgleichselement 27 verbunden ist. Das Aufnahmeelement 29 weist mehrere Bohrungen 30 auf, die das Aufnahmeelement 29 fest mit der nicht dargestellten Haltevorrichtung verbinden. Dabei weist die Haltevorrichtung eine weitere Steckverbindung auf, die in die Bohrlöcher 30 greift. Selbstverständlich kann auch das Aufnahmeelement 29 über eine Steckverbindung verfügen, die im Weiteren in Bohrlöcher der nicht dargestellten Haltevorrichtung greift. Zur Unterstützung kann die Oberfläche des Ausnahmeelements 29 und/oder die Oberfläche der nicht dargestellten Haltevorrichtung magnetisch sein, um dadurch eine sichere Befestigung der Messvorrichtung 11 an der nicht dargestellten Haltevorrichtung sicherzustellen.

In einem nicht dargestellten erfindungsgemäßen Ausführungsbeispiel ist die Messvorrichtung 11 federnd mit der Haltevorrichtung verbunden. Dies kann z.B. durch eine federnde Steckverbindung erfolgen, die in die Bohrlöcher 30 des Aufnahmeelements 29 greifen. Die Datenübertragung kann in diesem Fall über ein flexibles Folienkabel zu den Anschlussbuchsen 25 erfolgen.

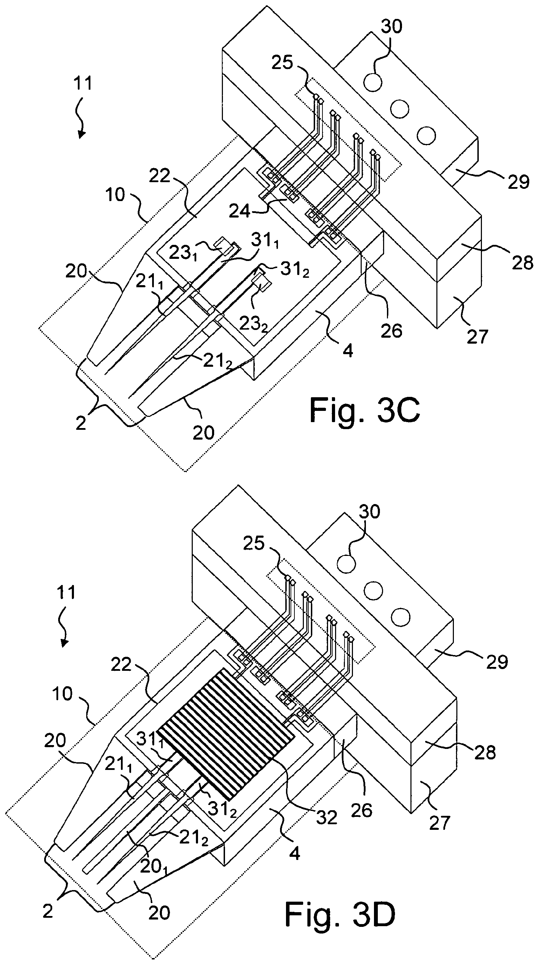

Fig. 3B zeigt eine räumliche Darstellung eines weiteren möglichen Ausführungsbeispiels der erfindungsgemäßen Messvorrichtung 11. Die erfindungsgemäße Messvorrichtung ist im Wesentlichen analog zu dem erfindungsgemäßen Ausführungsbeispiel aus Fig. 3A aufgebaut, weshalb auf Beschreibung hierzu verwiesen wird. Das erfindungsgemäße Ausführungsbeispiel aus Fig. 3B weist allerdings zwei Messsignalkontaktierungen 21₁, 21₂ und eine weitere Massekontaktierung 20₁ auf. Die Messsignalkontaktierung 21₁ ist über die Streifenleitung 31₁ mit dem Heizwiderstand 23₁ elektrisch leitend verbunden. Die Messsignalkontaktierung 21₂ ist über die Streifenleitung 31₂ mit dem Heizwiderstand 23₂ elektrisch leitend verbunden. Im Unterschied zu dem Ausführungsbeispiel aus Fig. 3A können mittels der beiden Messsignalkontaktierungen 21₁, 21₂ die Leistungen von zwei verschiedenen Signalen gleichzeitig erfasst werden. Um eine gegenseitige Beeinflussung zu vermeiden, sind die beiden Heizwiderstände 23₁, 23₂ räumlich weiter voneinander entfernt, als dies in dem Ausführungsbeispiel in Fig. 3A dargestellt ist. Um Masseschleifen zu reduzieren und die gegenseitige Beeinflussung der Messsignale auf den einzelnen Messsignalkontaktierungen 21₁, 21₂ zu verringern, ist zwischen den einzelnen Messsignalkontaktierungen 21₁, 21₂ eine weitere Massekontaktierung 20₁ ausgebildet. Diese weitere Massekontaktierung 20₁ ist allerdings nicht ganz so breit, wie die bereits vorhandene Massekontaktierung 20. Bevorzugt besteht die Messspitze 2 dabei aus je einer Massekontaktierung 20 am Rand und einer weiteren Massekontaktierung 20₁ in der Mitte, zwischen denen die Messsignalkontaktierungen 21₁, 21₂ ausgebildet sind. Dabei entsteht die Signalfolge Masse - Signal 1 - Masse - Signal 2 - Masse (engl. ground-signal-ground-signal-ground). Fig. 3C zeigt eine räumliche Darstellung eines weiteren möglichen Ausführungsbeispiels der erfindungsgemäßen Messvorrichtung 11. Die erfindungsgemäße Messvorrichtung 11 ist im Wesentlichen analog zu dem erfindungsgemäßen Ausführungsbeispiel aus Fig. 3B aufgebaut, weshalb auf die Beschreibung hierzu verwiesen wird. Der einzige Unterschied besteht darin, dass die weitere Massekontaktierung 20₁ nicht vorhanden ist und der Aufbau daher einfacher erfolgen kann.

Fig. 3D zeigt eine räumliche Darstellung eines weiteren möglichen Ausführungsbeispiels der erfindungsgemäßen Messvorrichtung 11. Der Aufbau der Messspitze 2 entspricht demjenigen aus der Beschreibung zu Fig. 3B. Im Unterschied dazu handelt es sich bei dem Messwandler 4 nicht mehr um einen thermischen Leistungssensor. Der Messwandler 4 beinhaltet stattdessen einen I/Q-Demodulator (engl. inphase/quadrature; dt. richtigphasig/Quadratur) und/oder einen Analog/Digital-Wandler. Damit ist es z.B. möglich Verstärkerschaltungen zu untersuchen, die ein digital moduliertes Signal verstärken. Am Ausgang des Inphase/Quadratur-Demodulators, dessen Chipstruktur 32 in Fig. 3D abgebildet ist, wird direkt die Inphase- und die Quadraturkomponente ausgegeben. Beispielsweise kann auf diese Art und Weise die EVM (engl. error vector magnitude; dt. Messwert zur Bestimmung der Modulationsqualität) von einer Verstärkerschaltung gemessen werden, so dass fehlerhafte Verstärkerschaltungen schon erkannt werden können, noch bevor diese vom Wafer separiert werden. Bei der Chipstruktur 32 kann es sich statt dem Inphase/Quadratur-Demodulator auch um einen Analog/Digital-Wandler handeln, mit dem der Signalverlauf des Messsignals erfasst werden kann. Aufgrund der beiden Messsignalkontaktierungen 21₁, 21₂ kann das Messsignal entweder differentiell erfasst werden, oder es können zwei verschiedene Signale gegenüber der Bezugsmasse gemessen werden. Die Art der Messung kann dabei jederzeit geändert werden. Um die Chipstruktur 32 vor Umwelteinflüssen zu schützen, muss der Messwandler 4 noch in ein luftdichtes Gehäuse 65 eingepackt werden. Selbstverständlich kann auf die zusätzliche Massekontaktierung 20₁ je nach Anwendungsfall auch verzichtet werden.

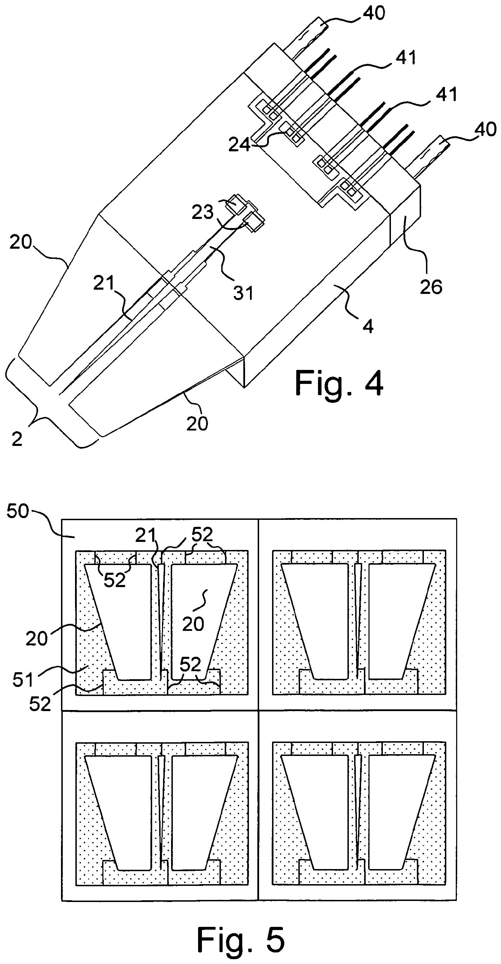

Fig. 4 zeigt eine räumliche Darstellung eines möglichen Ausführungsbeispiels eines Teils der erfindungsgemäßen Messvorrichtung 11. Dargestellt ist die Messeinheit 10 und das Verbindungselement 26, wie sie bereits in der Fig. 3A beschrieben sind, worauf hiermit verwiesen wird. Das Verbindungselement 26 weist ferner noch eine Steckverbindung auf. Die Steckverbindung weist Stecker 40 zur mechanischen Befestigung und mehrere Kontaktstecker 41 zur Übertragung von verschiedenen Signalen auf. Selbstverständlich kann es sich auch um Buchsen handeln, so dass die Stecker selbst in der Ausgleichsvorrichtung 27 ausgebildet sind.

Die Messspitze 2 und der Messwandler 4 können sehr einfach gemeinsam durch Abziehen von der Messvorrichtung 11 getauscht werden. Dies gelingt dadurch, dass die Messspitze 2, der Messwandler 4 und das Verbindungselement 26 eine Einheit bilden, die von Halterungselementen, wie z.B. der Ausgleichsvorrichtung 27 lösbar ist. Dadurch ist es möglich, dass eine defekte Messspitze 2 möglichst einfach und kostengünstig getauscht werden kann. Besonders vorteilhaft ist dabei, dass sowohl die Messspitze 2, als auch der Messwandler 4 gegen eine neue Messspitze 2 und einen neuen Messwandler 4 getauscht werden. Diese neuen Komponenten wurden bereits bei der Herstellung vollumfänglich vermessen, so dass im Weiteren eine erneute Kalibration nicht notwendig ist. Es müssen einzig die Kalibrationsdaten in die digitale Signalverarbeitungseinheit 7 geladen werden.

Fig. 5 zeigt ein Ausführungsbeispiel zur Herstellung der erfindungsgemäßen Messspitze 2. Die Messspitze 2 wird bevorzugt in einem Ätzprozess hergestellt. Als Ausgangspunkt dient ein Opfermaterial 51 auf das eine dünne elektrisch leitende Metallschicht 50 aufgetragen ist. Anschließend wird auf diese Metallschicht 50 ein Fotolack aufgetragen und die Messspitze 2 als Schablone aufgelegt. Im nächsten Schritt wird das Opfermaterial 51 samt Schablone belichtet, wofür sich insbesondere ultraviolettes Licht eignet. In einem weiteren Schritt wird die Metallschicht 50 weggeätzt, die während dem Belichtungsprozess nicht von der Schablone bedeckt war.

Fig. 5 zeigt die Messspitze 2 auf dem Opfermaterial 51 nach dem Ätzprozess, bevor diese von dem Opfermaterial 50 durch einen weiteren Ätzprozess abgelöst wird. Gut zu erkennen sind die Strukturen der Messspitze 2. Über kleine Stege 52, die ebenfalls aus dem Metall 50 bestehen, ist die Messspitze 2 noch mit dem umgebenden Metallrand 50 verbunden. Die Messspitze 2 wird samt dem Metallrand 50 von dem Opfermaterial 51 gelöst und auf die entsprechende Stelle am Messwandler 4 platziert. Anschließend wird die Messspitze 2 mit dem Messwandler 4 dauerhaft verbunden. In einem letzten Schritt werden die Stege 52 entfernt, die dazu dienen, die Messspitze 2 sehr genau ausrichten zu können. Durch den Ätzprozess sind sehr feine Strukturierungen möglich, so dass die Spitze der Messsignalkontaktierung 21 eine optimale Form erhält. Aufgrund der sehr kleinen Abmessungen der Messspitze 2 können auf ein mit Metall 50 beschichtetes Opfermaterial 51 mehrere Messspitzen 2 zu selben Zeit hergestellt werden. Bei dem Opfermaterial 51 handelt es sich bevorzugt um einen Opferwafer, bzw. ein Opfersubstrat. Ebenfalls ist denkbar, dass es sich bei dem Opfermaterial 51 auch um eine flexible Folie handelt, von welcher die Messspitze 2 abgezogen wird.

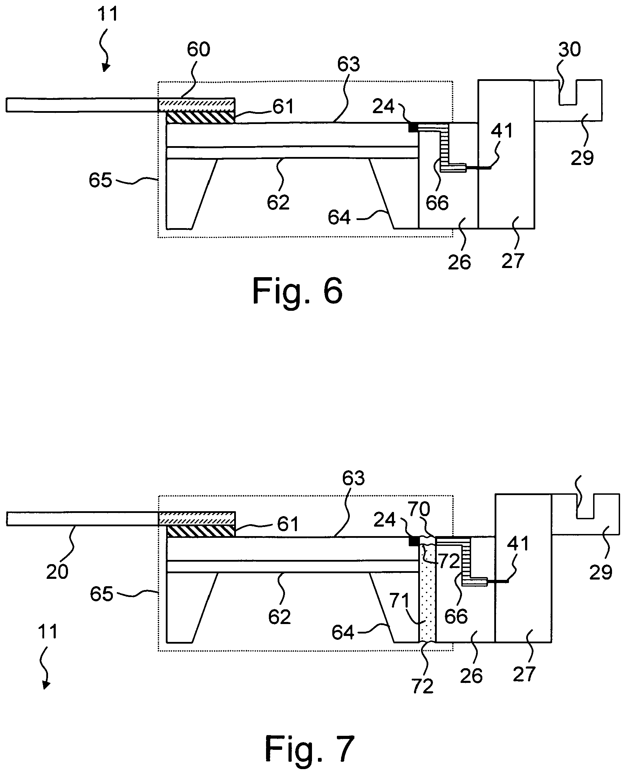

Fig. 6 zeigt eine vereinfachte Schnittzeichnung der erfindungsgemäßen Messvorrichtung 11 entlang der der Achse I. Der Messwandler 4 ist stark vereinfacht dargestellt. Er besteht im Wesentlichen aus drei Schichten. Ein Rahmen 64 dient zu Stabilisierung des Messwandlers 4 und stellt sein Grundgerüst dar. Der Rahmen 64 stellt auch einen definierten Wärmeübergangswiderstand in Richtung der Ausgleichsvorrichtung 27 über das Verbindungselement 26 dar. Oberhalb des Rahmens 64 ist eine erste Schicht 62 angeordnet, die unter anderem die Heizwiderstände 23 beinhaltet. Oberhalb der ersten Schicht 62 ist eine zweite Schicht 63 ausgebildet, die die einzelnen Thermoelemente 80 beinhaltet. Auf einem Teil der zweiten Schicht 63 ist eine Metallisierungsschicht 61 ausgebildet. Auf dieser

Metallisierungsschicht 61 wird die Messspitze 2 angeordnet. Z.B. mittels Thermokompression wird der Messwandler 4 mit der Messspitze 2 zu einer Messeinheit 10 verbunden. Ein hoher Anpressdruck zusammen mit einer hohen Temperatur sorgt beim Thermokompressionsverfahren dafür, dass eine dauerhafte, mechanisch stabile und in diesem Fall elektrisch leitende Verbindung entsteht. Die Messspitze 2 kann auch z.B. mittels Wafer-Bonden oder Flip-Chip-Bonden mit dem Messwandler 4 zu einer Messeinheit 10 verbunden werden. Neben dem eben genannten getrennten mikrotechnologischen Verfahren, können die Messspitze 2 und der Messwandler 4 auch in einem gemeinsamen mikrotechnologischen Verfahren zu einer Messeinheit 10 hergestellt werden. In diesem Fall wird bereits auf dem Halbleiter-Substrat, das zur Aufnahme des Messwandlers 4 dient, die Struktur der Messspitze 2 geschaffen.

Bevorzugt ist der Messwandler 4 von einem Gehäuse 65 umgeben, welches den Messwandler 4 gegenüber der Umgebung thermisch isoliert. Das Gehäuse 65 weist Öffnungen für das Verbindungselement 26 und die Messspitze 2 auf. Der Übergang 60 der Messspitze 2 zum Messwandler 4, welcher sich innerhalb des Gehäuses 65 befindet, ist aus einem schlecht wärmeleitfähigen Material gebildet oder überzogen, so dass sich die Temperatur des zu untersuchenden Wafers 1 nicht auf die Messergebnisse des Messwandlers 4 auswirkt.

Die Verbindungsanschlüsse 24 werden innerhalb des Verbindungselements 26 über die Verbindung 66 mit dem Kontaktstecker 41 elektrisch verbunden. Ebenfalls gut zu erkennen ist das Bohrloch 30 innerhalb des Aufnahmeelements 29. Das Bohrloch ist in diesem Fall als Sackbohrung ausgeführt. Allerdings sind auch andere Bohrformen denkbar.

Fig. 7 zeigt eine vereinfachte Schnittzeichnung eines weiteren erfindungsgemäßen Ausführungsbeispiels der Messvorrichtung 11 entlang der der Achse I. Der Unterschied zu dem Ausführungsbeispiel aus Fig. 6 besteht darin, dass der Messwandler 4 federnd mit dem Verbindungselement 26 verbunden ist. Das Verbindungselement 26 ist dabei über ein Folienkabel 70 mit der Verbindung 66 verbunden. Der Spalt zwischen dem Messwandler 4 und dem Verbindungselement 26 ist dabei mit einem wärmeleitfähigen Material 71, welches z.B. eine gelartige und/oder elastische und/oder pastenartige Konsistenz aufweist, gefüllt. Elastische Dichtungen 72 sorgen ggf. dafür, dass dieses wärmeleitfähige Material 71 nicht austritt.

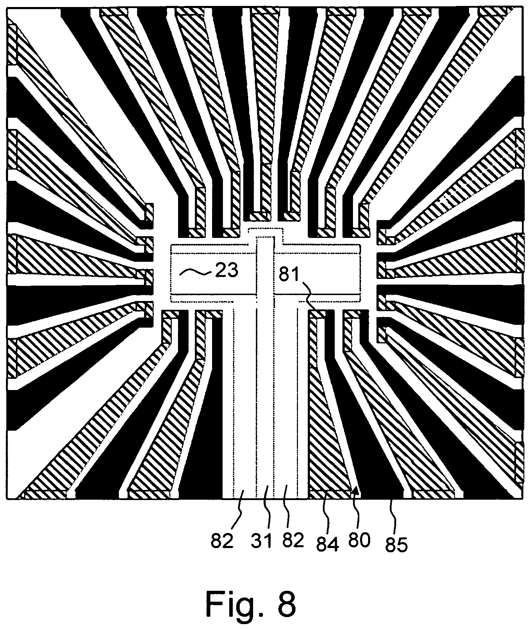

Fig. 8 zeigt eine Draufsicht auf die zweite Schicht 63 mit den entsprechenden Thermoelementen 80. Jedes Thermoelement 80 besteht aus zwei verschiedenen Metallen oder Metalllegierungen, die sich an einem Punkt berühren. Die Thermoelemente 80 sind an ihrem aktiven Bereich 81 galvanisch getrennt voneinander angeordnet. Jedes Thermoelement 80 wird z.B. von einer Kupfer-Nickel-Zuleitung 84, einer Kupfer-Zuleitung 85 und einem aktiven Bereich 81 gebildet. Die Ausführungsform ist dabei nicht auf die genannten Materialien beschränkt. Verschiedene Thermoelemente 80 können dabei in Reihe geschaltet sein, um den Signalpegel zu erhöhen.

Eine andere Anordnung der Thermoelemente 80 ist ebenfalls möglich. So kann die Kupfer-Nickel-Zuleitung 84 direkt über der Kuper-Zuleitung 85 verlaufen. Einzig eine Isolationsschicht trennt die beiden Schichten mit Ausnahme des aktiven Bereichs 81 voneinander. Dadurch kann die Entstehung von Messschleifen verringert werden, in die elektromagnetische Felder eine Störspannung induzieren können, die der Thermospannung überlagert ist.

Die aktiven Bereiche 81 der Thermoelemente 80 sind nahe zu den gepunktet angedeuteten Heizwiderständen 23 angeordnet. Über die Streifenleitung 31 sind die Heizwiderstände 23 mit der Messsignalkontaktierung 21 der Messspitze 2 verbunden. Über die Aussparung 82 wird die Streifenleitung 31 von der Massefläche isoliert. Die Thermoelemente 80 sind weiterhin durch isolierende Schichten bezüglich den darüber und darunter liegenden Schichten galvanisch getrennt.

Für den Fall dass zwei Messsignalkontaktierungen 21₁, 21₂ und damit zwei getrennt voneinander arbeitende Heizwiderstände 23₁, 23₂ Anwendung finden, müssen die Thermoelemente 80 derart miteinander verschaltet werden, dass die Heizwiderstände 23₁, 23₂ nicht jeweils die Thermoelemente 80 beeinflussen, die für die Messung der Leistung des jeweils anderen Messsignals zuständig sind.

Die Erfindung ist nicht auf die gezeigten Ausführungsbeispiele beschränkt. Alle beschriebenen und/oder gezeichneten Merkmale können im Rahmen der Erfindung miteinander kombiniert werden.

Die Erfindung ist nicht nur für Wafer-Messvorrichtungen sondern auch zum Prüfen von bereits bestückten Platinen geeignet. Auch Messwandler, die nach dem Gleichrichterprinzip mit Dioden arbeiten, können in die Messvorrichtung 11 eingesetzt werden.

## Patentansprüche

1. Messvorrichtung (11) zur Erfassung eines Messsignals von einer auf einem Wafer (1) aufgebrachten Schaltungsstruktur,
mit zumindest einer Messspitze (2) und zumindest einem Messwandler (4),
wobei der zumindest eine Messwandler (4) mit der zumindest einen Messspitze (2) elektrisch leitend verbunden ist, wobei der Messwandler (4) an der Messspitze (2) angeordnet ist und eine untrennbare Messeinheit (10) bilden
**dadurch gekennzeichnet,**
**dass** die Messvorrichtung (11) weiterhin eine Wärmesenke in Form einer Ausgleichsvorrichtung (27) aufweist, wobei die Ausgleichsvorrichtung (27) mechanisch fest mit einem Aufnahmeelement (29) verbunden ist und aus Gold oder Messing besteht,
**dass** die Messvorrichtung (11) ein Verbindungselement (26) aufweist, welches mit dem Messwandler (4) und der Ausgleichsvorrichtung (27) verbunden ist, wobei das Verbindungselement (26) aus Gold oder Messing besteht, dass die Messspitze (2) und der Messwandler (4) gemeinsam durch Abziehen von der Messvorrichtung (11) tauschbar sind und
**dass** es sich bei dem Messwandler (4) um einen thermischen Leistungssensor handelt.

2. Messvorrichtung nach Anspruch 1,
**dadurch gekennzeichnet,**
**dass** es sich bei dem Messsignal um ein Hochfrequenz-Signal handelt.

3. Messvorrichtung nach einem der vorherigen Ansprüche,
**dadurch gekennzeichnet,**
**dass** der Messwandler (4) eine analoge Gleichspannung ausgibt, die proportional zu einer Leistung des Messsignals ist.

4. Messvorrichtung nach einem der vorherigen Ansprüche,
**dadurch gekennzeichnet,**
**dass** der Messwandler (4) durch ein Gehäuse (65) thermisch von seiner Umgebung isoliert ist.

5. Messvorrichtung nach einem der vorherigen Ansprüche,
**dadurch gekennzeichnet,**
**dass** die Messspitze (2) zumindest eine Messsignalkontaktierung (21) und zumindest eine Massekontaktierung (20) aufweist, die als eigenständige Spitzen (20, 21) ausgebildet sind.

6. Messvorrichtung nach einem der vorherigen Ansprüche,
**dadurch gekennzeichnet,**
**dass** die Messspitze (2) zwei Messsignalkontaktierungen (21₁, 21₂) aufweist, um wahlweise das eine Messsignal differentiell oder zwei verschiedene Messsignale aufzunehmen, oder
**dass** die Messspitze (2) zwei Messsignalkontaktierungen (21₁, 21₂) und eine weitere Massekontaktierung (20₁) aufweist, um wahlweise das eine Messsignal differentiell oder zwei verschiedene Messsignale aufzunehmen.

7. Messvorrichtung nach Anspruch 5 oder 6,
**dadurch gekennzeichnet,**
**dass** die zumindest eine Messsignalkontaktierung (21) oder die zwei Messsignalkontaktierungen (21₁, 21₂) und die zumindest eine Massekontaktierung (20) oder die weitere Massekontaktierung (20₁) der Messspitze (2) als eigenständige Spitzen (20, 20₁, 21, 21₁, 21₂) ausgebildet sind.

8. Messvorrichtung nach einem der vorherigen Ansprüche,
**dadurch gekennzeichnet,**
**dass** die Messspitze (2) und der Messwandler (4) in einem mikrotechnologischen Verfahren als eine gemeinsame Messeinheit (10) hergestellt sind.

9. Messvorrichtung nach einem der vorherigen Ansprüche,
**dadurch gekennzeichnet,**
**dass** die Messspitze (2) und der Messwandler (4) in getrennten mikrotechnologischen Verfahren hergestellt werden und mittels einer dauerhaften Verbindung, insbesondere mittels Wafer-Bonden oder Flip-Chip-Bonden oder Thermokompression, zu einer Messeinheit (10) verbunden sind.

10. Messvorrichtung nach einem der vorherigen Ansprüche,
**dadurch gekennzeichnet,**
**dass** die Messspitze (2) federnd mit dem Messwandler (4) verbunden ist.

11. Messvorrichtung nach einem der vorherigen Ansprüche,
**dadurch gekennzeichnet,**
**dass** der Messwandler (4) federnd mit einem Verbindungselement (26) verbunden ist.

12. Messvorrichtung nach einem der vorherigen Ansprüche,
**dadurch gekennzeichnet,**
**dass** die Messvorrichtung (11) ein Verbindungselement (26) aufweist, das eine Steckverbindung beinhaltet und dazu dient, die Anschlusskontakte (24) des Messwandlers (4) mit der Steckverbindung zu kontaktieren.

## Claims

1. A measuring device (11) for registering a test signal from a circuit structure applied to a wafer (1),
with at least one test probe (2) and at least one test transformer (4),
wherein the at least one test transformer (4) is connected in an electrically conductive manner to the at least one test probe (2),
wherein the test transformer (4) is disposed on the test probe (2) and forms an inseparable test unit (10),
**characterised in that**
the measuring device (11) further provides a heat sink in the form of a balancing device (27), wherein the balancing device (27) is connected mechanically in a rigid manner to a retaining element (29) and comprises gold or brass,
that the measuring device (11) provides a connecting element (26), which is connected to the test transformer (4) and to the balancing device (27), wherein the connecting element (26) comprises gold or brass,
that the test probe (2) and the test transformer (4) are jointly replaceable by withdrawing from the measuring device (11) and that the test transformer (4) is a thermal power sensor.

2. The measuring device according to any one of the preceding claims,
**characterised in that**
the test signal is a high-frequency signal.

3. The measuring device according to any one of the preceding claims,
**characterised in that**
the test transformer (4) outputs an analog, direct voltage, which is proportional to a power of the test signal.

4. The measuring device according to any one of the preceding claims,
**characterised in that**
the test transformer (4) is thermally insulated from its surroundings by a housing (65).

5. The measuring device according to any one of the preceding claims,
**characterised in that**
the test probe (2) provides at least at one test-signal contact (21) and at least one ground contact (20), which are embodied as independent probes (20, 21).

6. The measuring device according to any one of the preceding claims,
**characterised in that**
the test probe (2) provides two test-signal contacts (21₁, 21₂) in order optionally to pick up the one test signal differentially or to pick up two different test signals, or
that the test probe (2) provides two test-signal contacts (21₁, 21₂) and a further ground contact (20₁) in order optionally to pick up the one test signal differentially or to pick up two different test signals.

7. The measuring device according to claim 5 or 6,
**characterised in that**
the at least one test-signal contact (21) or the two test-signal contacts (21₁, 21₂) and the at least one ground contact (20) or the further ground contact (20₁) of the test probe (2) are embodied as independent probes (20, 20₁, 21, 21₁, 21₂) .

8. The measuring device according to any one of the preceding claims,
**characterised in that**
the test probe (2) and the test transformer (4) are manufactured as a combined test unit (10) in a micro-engineering process.

9. The measuring device according to any one of the preceding claims,
**characterised in that**
the test probe (2) and the test transformer (4) are manufactured in separate micro-engineering processes and connected to form a test unit (10) by means of a permanent connection, especially by means of wafer-bonding or flip-chip bonding or thermo-compression.

10. The measuring device according to any one of the preceding claims,
**characterised in that**
the test probe (2) is connected to the test transformer (4) in an elastic manner.

11. The measuring device according to any one of the preceding claims,
**characterised in that**
the test transformer (4) is connected to a connecting element (26) in an elastic manner.

12. The measuring device according to any one of the preceding claims,
**characterised in that**
the measuring device (11) provides a connecting element (26), which contains a plug connection and serves to contact the terminal contacts (24) of the test transformer (4) with the plug connection.

## Revendications

1. Dispositif de mesure (11) pour détecter un signal de mesure d'une structure de circuit appliquée sur une galette (1),
avec au moins une pointe de mesure (2) et au moins un transducteur de mesure (4),
où le au moins un transducteur de mesure (4) est relié de manière électriquement conductrice avec la au moins une pointe de mesure (2),
où le transducteur de mesure (4) est disposé sur la pointe de mesure (2) et forment une unité de mesure indissociable (10)
**caractérisé en ce que** le dispositif de mesure (11) présente en outre un dissipateur thermique sous forme d'un dispositif de compensation (27), où le dispositif de compensation (27) est relié de manière fixe mécaniquement avec un élément de réception (29) et consiste en or ou en laiton,
**en ce que** le dispositif de mesure (11) présente un élément de liaison (26) qui est relié avec le transducteur de mesure (4) et le dispositif de compensation (27), où l'élément de liaison (26) consiste en or ou en laiton,
**en ce que** la pointe de mesure (2) et le transducteur de mesure (4) peuvent être remplacés ensemble par retrait du dispositif de mesure (11)
et
**en ce que** le transducteur de mesure (4) est un capteur de puissance thermique.

2. Dispositif de mesure selon la revendication 1, **caractérisé en ce que** le signal de mesure est un signal haute fréquence.

3. Dispositif de mesure selon l'une des revendications précédentes, **caractérisé en ce que** le transducteur de mesure (4) délivre une tension continue analogique qui est proportionnelle à une puissance du signal de mesure.

4. Dispositif de mesure selon l'une des revendications précédentes, **caractérisé en ce que** le transducteur de mesure (4) est isolé thermiquement de son environnement par un boîtier (65).

5. Dispositif de mesure selon l'une des revendications précédentes, **caractérisé en ce que** la pointe de mesure (2) présente au moins une connexion de signal de mesure (21) et au moins une connexion de masse (20) qui sont agencées sous forme de pointes autonomes (20, 21).

6. Dispositif de mesure selon l'une des revendications précédentes, **caractérisé en ce que** la pointe de mesure (2) présente deux connexions de signal de mesure (21₁, 21₂) pour recevoir au choix un signal de mesure de manière différentielle ou deux signaux de mesure différents, ou
**en ce que** la pointe de mesure (2) présente deux connexions de signal de mesure (21₁, 21₂) et une connexion de masse supplémentaire (20₁) pour recevoir au choix un signal de mesure de manière différentielle ou deux signaux de mesure différents.

7. Dispositif de mesure selon la revendication 5 ou 6, **caractérisé en ce que** la au moins une connexion de signal de mesure (21) ou les deux connexions de signal de mesure (21₁, 21₂) et la au moins une connexion de masse (20) ou la connexion de masse supplémentaire (20₁) de la pointe de mesure (2) sont agencées sous forme de pointes autonomes (20, 20₁, 21, 21₁, 21₂).

8. Dispositif de mesure selon l'une des revendications précédentes, **caractérisé en ce que** la pointe de mesure (2) et le transducteur de mesure (4) sont fabriqués dans un procédé microtechnologique sous forme d'une unité de mesure (10) commune.

9. Dispositif de mesure selon l'une des revendications précédentes, **caractérisé en ce que** la pointe de mesure (2) et le transducteur de mesure (4) sont fabriqués dans des procédés microtechnologiques séparés et sont reliés en une unité de mesure (10) au moyen d'une liaison durable, en particulier au moyen d'une connexion de galette ou d'une connexion à puce retournée ou d'une thermocompression.

10. Dispositif de mesure selon l'une des revendications précédentes, **caractérisé en ce que** la pointe de mesure (2) est reliée élastiquement au transducteur de mesure (4).

11. Dispositif de mesure selon l'une des revendications précédentes, **caractérisé en ce que** le transducteur de mesure (4) est relié élastiquement à un élément de liaison (26).

12. Dispositif de mesure selon l'une des revendications précédentes, **caractérisé en ce que** le dispositif de mesure (11) présente un élément de liaison (26) qui contient une liaison à fiche et sert à mettre en contact les contacts de raccordement (24) du transducteur de mesure (4) avec la liaison à fiche.
